# EUROPEAN PATENT APPLICATION

(11) **EP 4 626 181 A1**
(43) Date of publication of application: **01.10.2025**
(21) Application number: 24821243.3
(22) Date of filing: 02.04.2024
(51) Int. Cl.: H10F 10/14, H10F 77/30, H10F 77/20, H10F 71/00

(54) **SOLAR CELL AND MANUFACTURING METHOD FOR SOLAR CELL**

(30) Priority: 05.02.2024 CN 202410160857
(71) Applicant: Trina Solar Co., Ltd, Changzhou, Jiangsu 213031 (CN)
(72) Inventor: YANG, Guangtao, Changzhou, Jiangsu 213031 (CN)
(74) Representative: Nederlandsch Octrooibureau
(86) International application number: PCT/CN2024/085448
(87) International publication number: WO 2025/166888

(57) **Abstract**

The present application provides a solar cell and a method for manufacturing a solar cell. The solar cell comprises a substrate having a front side and a back side opposite to each other, and the back side has a first region and a second region adjacent to each other in a first direction; a first electrode region disposed below the first region; a second electrode region disposed below the second region; a cantilever structure comprising a main portion and an extension portion connected in the first direction, wherein the main portion contacts a back side of the first electrode region, the extension portion protrudes from the first electrode region in the first direction; and a first passivation layer and a second doped layer located below the first region and the second region, wherein the first passivation layer and the second doped layer extend from the second region to a back side of the cantilever structure, the second electrode region includes a first passivation layer and a second doped layer formed on the second region, a thickness of a portion of the first passivation layer located on a side of the first electrode region gradually decreases in a direction approaching the extension portion, and a thickness of a portion of the second doped layer located on a side of the first electrode region gradually decreases in a direction approaching the extension portion. The solar cell and the method for manufacturing a solar cell of the present application can significantly reduce or eliminate the short-circuit effect between adjacent electrodes.

## Description

### Technical Field

The present application mainly relates to the field of photovoltaic technology, and specifically to a solar cell and a method for manufacturing a solar cell.

### Background

The types of solar cells mainly include Passivated Emitter and Rear Contact (PERC), Tunnel Oxide Passivated Contact (TOPcon), Hetero-Junction with Intrinsic Thin Film (HIT) and Interdigitated Back Contact (IBC), etc. Among them, PERC cells are the mainstream type of solar cells in the current market, and their mass production efficiency is close to the theoretical limit. Although the photoelectric conversion efficiency of solar cells has gradually increased with the development of solar cell technology, the market's pursuit of higher photoelectric conversion efficiency will never stop.

### Brief Summary

The technical problem to be solved by the present application is to provide a solar cell and a method for manufacturing a solar cell, which can significantly reduce or eliminate the short-circuit effect between adjacent electrodes.

In order to achieve above purpose, the present application proposes a solar cell, comprising: a substrate having a front side and a back side opposite to each other, and the back side has a first region and a second region adjacent to each other in a first direction; a first electrode region disposed below the first region; a second electrode region disposed below the second region; a cantilever structure comprising a main portion and an extension portion connected in the first direction, wherein the main portion contacts a back side of the first electrode region, the extension portion protrudes from the first electrode region in the first direction; and a first passivation layer and a second doped layer located below the first region and the second region, wherein the first passivation layer and the second doped layer extend from the second region to a back side of the cantilever structure, the second electrode region includes a first passivation layer and a second doped layer formed on the second region, a thickness of a portion of the first passivation layer located on a side of the first electrode region gradually decreases in a direction approaching the extension portion, and a thickness of a portion of the second doped layer located on a side of the first electrode region gradually decreases in a direction approaching the extension portion.

In an embodiment, the first electrode region comprises a tunneling layer and a first doped layer, and the tunneling layer and the first doped layer are sequentially arranged below the first region.

In an embodiment, the first passivation layer and the second doped layer continuously extend to the back side of the cantilever structure.

In an embodiment, a thickness of a portion of the first passivation layer located above the extension portion gradually increases in a direction away from the main portion, and a thickness of a portion of the second doped layer located above the extension portion gradually increases in a direction away from the main portion.

In an embodiment, the first passivation layer and the second doped layer extend discontinuously to the back side of the cantilever structure, wherein the first passivation layer and the second doped layer are disconnected at a junction of the main portion and the extension portion.

In an embodiment, a thickness of a portion of the first passivation layer located above the extension portion gradually increases in a direction away from the main portion, and a thickness of a portion of the second doped layer located above the extension portion gradually increases in a direction away from the main portion.

In an embodiment, the solar cell further comprises a transparent conductive layer located on a back side of the second doped layer, wherein a thickness of a portion of the transparent conductive layer located on a side of the first electrode region gradually decreases in a direction approaching the extension portion, and a thickness of a portion of the transparent conductive layer located above the extension portion gradually increases in a direction away from the main portion.

In an embodiment, a distance between a left end of the extending portion and the transparent conductive layer located at a right end of the extending portion is equal to or greater than 200 nm.

In an embodiment, the solar cell further comprises a first grid and a second grid, wherein the first grid is in electrical contact with the first electrode region through a contact hole.

In an embodiment, the first grid includes a second contact portion and a plurality of first contact portions, each of the first contact portions is in a corresponding contact hole, one end of each of the first contact portions contacts the first electrode region, and another end contacts the second contact portion.

In an embodiment, a width of each of the first contact portions is smaller than a width of the second contact portion.

In order to achieve above purpose, the present application also proposes a method for manufacturing a solar cell, comprising: providing a substrate having a front side and a back side opposite to each other, and the back side has a first region and a second region adjacent to each other in a first direction; forming a first electrode region below the first region; forming a second electrode region below the second region; forming a cantilever structure comprising a main portion and an extension portion connected in the first direction, wherein the main portion contacts a back side of the first electrode region, the extension portion protrudes from the first electrode region in the first direction; and forming a first passivation layer and a second doped layer, the first passivation layer and the second doped layer extending from the second region to a back side of the cantilever structure, wherein the second electrode region includes a first passivation layer and a second doped layer formed on the second region, and a thickness of a portion of the first passivation layer located on a side of the first electrode region gradually decreases in a direction approaching the extension portion, a thickness of a portion of the second doped layer located on the side of the first electrode region gradually decreases in a direction approaching the extension portion.

In an embodiment, the first electrode region comprises a tunneling layer and a first doped layer, and the tunneling layer and the first doped layer are sequentially arranged below the first region.

In an embodiment, the first passivation layer and the second doped layer extend continuously to the back side of the cantilever structure.

In an embodiment, a thickness of a portion of the first passivation layer located above the extension portion gradually increases in a direction away from the main portion, and a thickness of a portion of the second doped layer located above the extension portion gradually increases in a direction away from the main portion.

In an embodiment, the first passivation layer and the second doped layer extend discontinuously to the back side of the cantilever structure, wherein the first passivation layer and the second doped layer are disconnected at a junction of the main portion and the extension portion.

In an embodiment, a thickness of a portion of the first passivation layer located above the extension portion gradually increases in a direction away from the main portion, and a thickness of a portion of the second doped layer located above the extension portion gradually increases in a direction away from the main portion.

In an embodiment, the method further comprises forming a transparent conductive layer located on a back side of the second doped layer, wherein a thickness of a portion of the transparent conductive layer located on a side of the first electrode region gradually decreases in a direction approaching the extension portion, and a thickness of a portion of the transparent conductive layer located above the extension portion gradually increases in a direction away from the main portion.

In an embodiment, a distance between a left end of the extension portion and the transparent conductive layer located at a right end of the extension portion is equal to or greater than 200 nm.

In an embodiment, the method further comprises forming a first grid and a second grid, wherein the first grid is electrically in contact with the first electrode region through a contact hole.

In an embodiment, the first grid is formed after forming the transparent conductive layer, or the first grid is formed before forming the transparent conductive layer.

In an embodiment, the first grid includes a second contact portion and a plurality of first contact portions, each of the first contact portions is in a corresponding contact hole, one end of each of the first contact portions contacts the first electrode region, and another end contacts the second contact portion.

In an embodiment, a width of each of the first contact portions is smaller than a width of the second contact portion.

The cantilever structure in the solar cell and the method for manufacturing a solar cell of the present application can significantly reduce or eliminate the short-circuit effect between adjacent electrodes.

### Brief Description of the Drawings

In order to make the features and advantages of the present application more obvious and understandable, the specific implementation methods of the present application will be described in detail below in conjunction with the drawings, wherein:
Fig. 1 is a partial top view of a solar cell according to an embodiment of the present application;
Fig. 2 is a schematic cross-sectional view of the solar cell along line A-A in Fig. 1;
Fig. 3 is an enlarged schematic view of the dotted rectangular frame in Fig. 2 in one embodiment;
Fig. 4 is an enlarged schematic view of the dotted rectangular frame in Fig. 2 in another embodiment;
Fig. 5 is a schematic cross-sectional view of the solar cell along line B-B in Fig. 1;
Fig. 6 is a cross-sectional schematic diagram of a solar cell in one embodiment;
Fig. 7 is a cross-sectional schematic diagram of a solar cell in another embodiment;
Fig. 8 is a schematic cross-sectional view of a solar cell in one embodiment;
Fig. 9 is a schematic flow chart of a method for manufacturing a solar cell according to an embodiment of the present application;
Figs. 10 to 17 are schematic cross-sectional views of a solar cell during the process of manufacturing the solar cell.

Reference signs: substrate 110, front side 111, back side 112, first region 112a, second region 112b, first diffusion layer 120, cantilever structure 130, main portion 131, extension portion 132, contact hole 140, second diffusion layer 150, first doped layer 160, tunneling layer 170, first grid 180, first contact portion 181, second contact portion 182, second grid 190, first passivation layer 210, junction 220, second doped layer 230, transparent conductive layer 240, first isolation groove 250, second isolation groove 260, mesh 270, second passivation layer 280 and anti-reflection layer 290.

### Detailed Description

In order to make the above objects, features and advantages of the present application more comprehensible, the specific implementation manners of the present application will be described in detail below in conjunction with the accompanying drawings.

Many specific details are set forth in the following description to facilitate a full understanding of the present application, but the present application can also be implemented in other ways than those described here, so the present application is not limited by the specific embodiments disclosed below.

As indicated in this application and claims, the terms "a", "an", "an" and/or "the" do not refer to the singular and may include the plural unless the context clearly indicates an exception. Generally speaking, the terms "comprising" and "comprising" only suggest the inclusion of clearly identified steps and elements, and these steps and elements do not constitute an exclusive list, and the method or device may also contain other steps or elements.

In addition, it should be noted that the use of words such as "first" and "second" to define components is only for the convenience of distinguishing corresponding components. To limit the protection scope of this application. In addition, although the terms used in this application are selected from well-known and commonly used terms, some terms mentioned in the specification of this application may be selected by the applicant according to his or her judgment, and their detailed meanings are listed in this article described in the relevant section of the description. Furthermore, it is required that this application be understood not only by the actual terms used, but also by the meaning implied by each term.

The flow chart is used in this application to illustrate the operations performed by the system according to the embodiment of this application. The preceding or following operations are not necessarily performed in an exact order. Instead, various steps may be processed in reverse order or concurrently. At the same time, other operations are either added to these procedures, or a certain step or steps are removed from these procedures.

The solar cell and the method for manufacturing a solar cell of the present application will be described through specific embodiments.

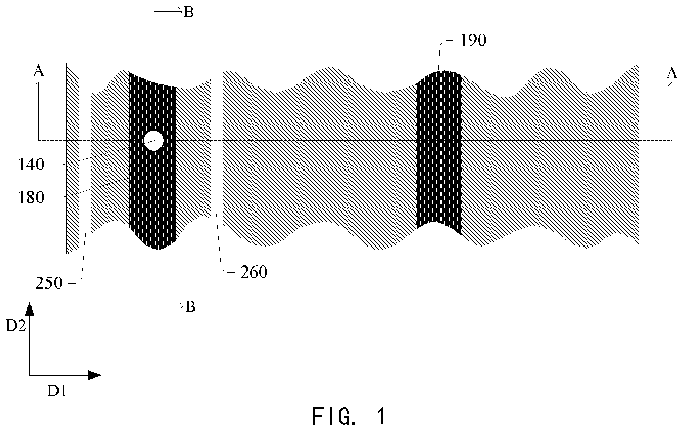

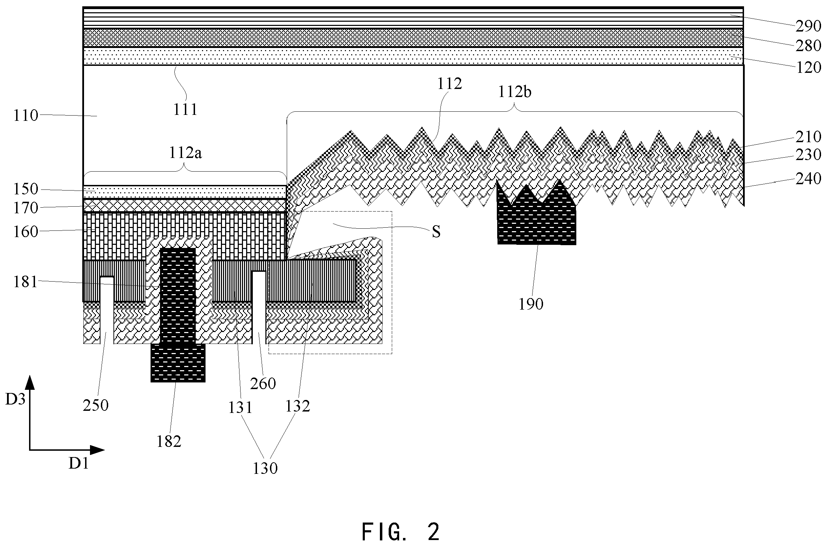

Fig. 1 is a partial top view of a solar cell according to an embodiment, and Fig. 2 is a cross-sectional view of the solar cell along line A-A in Fig. 1. Referring to Fig. 1 and Fig. 2, the solar cell includes a substrate 110, a first electrode region, a second electrode region and a cantilever structure 130.

Specifically, the substrate 110 has a front side 111 and a back side 112 opposite to each other in a third direction D3 (i.e., a thickness direction of the substrate 110). The back side 112 has a first region 112a and a second region 112b adjacent to each other in a first direction D1. When the solar cell is working, the front side 111 faces the sun.

The substrate 110 is doped. The substrate 110 may be N-type single-crystal silicon or P-type single-crystal silicon. When the substrate 110 is N-type single-crystal silicon, the doping element may be phosphorus (P) and/or arsenic (As), and when the substrate 110 is P-type single-crystal silicon, the doping element may be boron (B) and/or gallium (Ga).

The first electrode region is located below the first region 112a. The first electrode region may include a first doped layer 160 and a tunneling layer 170. The first doped layer 160 and the tunneling layer 170 are both located below the first region 112a, wherein the first doped layer 160 is located below the tunneling layer 170.

Specifically, the tunneling layer 170 is formed in the first region 112a, and the first doped layer 160 is formed on a surface of the tunneling layer 170 away from the substrate 110. The tunneling layer 170 can be selected from one or more of silicon oxide (SiOₓ), silicon oxynitride (SiO_{y}Nₓ), and aluminum oxide (Al₂O₃). The thickness of the tunneling layer 170 is equal to or less than 3nm, for example, 1nm, 1.5nm, 2nm, or 2.5nm. In some embodiments, the tunneling layer 170 contains the same doping element as the doping element in the substrate 110 and/or the first doped layer 160.

The first doped layer 160 may include doped polysilicon, and the doped polysilicon may contain one or more of oxygen (O), carbon (C), and nitrogen (N). The doping type of the first doped layer 160 may be the same as that of the substrate 110, or may be opposite to that of the substrate 110. In some embodiments, the thickness of the first doped layer 160 is equal to or greater than 20nm, and equal to or less than 600nm, for example, 50nm, 100nm, 150nm, 200nm, 250nm, 300nm, 350nm, 400nm, 450nm, 500nm, or 550nm. The first doped layer 160 has a passivation effect on the solar cell.

In some embodiments, the first electrode region further includes a second diffusion layer 150. The second diffusion layer 150 is directly formed on the first region 112a. The second diffusion layer 150 may include crystalline silicon (e.g., single crystal silicon and/or polycrystalline silicon), and the doping type of the second diffusion layer 150 is the same as or opposite to that of the substrate 110. The present application does not limit the doping concentration of the second diffusion layer 150. The doping concentration of the second diffusion layer 150 may be equal to or less than the doping concentration of the first doped layer 160, the doping concentration of the second diffusion layer 150 may also be greater than the doping concentration of the first doped layer 160, and the doping concentration of the second diffusion layer 150 may also be greater than the doping concentration of the substrate 110. The second diffusion layer 150 may be formed by diffusing the doping elements in the first doped layer 160 into the substrate 110 in the step of forming the first doped layer 160.

In the case where the solar cell has the second diffusion layer 150, the tunneling layer 170 and the first doped layer 160 are sequentially stacked on a surface of the second diffusion layer 150 away from the substrate 110 in the third direction D3.

The second electrode region is located below the second region 112b. Specifically, the first passivation layer 210 and the second doped layer 230 are sequentially arranged below the first region 112a and the second region 112b, and the first passivation layer 210 and the second doped layer 230 both extend from the second region 112b to the back of the cantilever structure 130. The first passivation layer 210 located below the second region 112b is directly formed on the second region 112b and extends to the back of the cantilever structure 130, and the second doped layer 230 is formed on the surface of the first passivation layer 210 away from the substrate 110. In some embodiments, the solar cell may not include the first passivation layer 210. In this case, the second doped layer 230 located below the second region 112b is directly formed on the second region 112b and extends to the back of the cantilever structure 130. The second electrode region includes the first passivation layer 210 and the second doped layer 230 formed on the second region 112b.

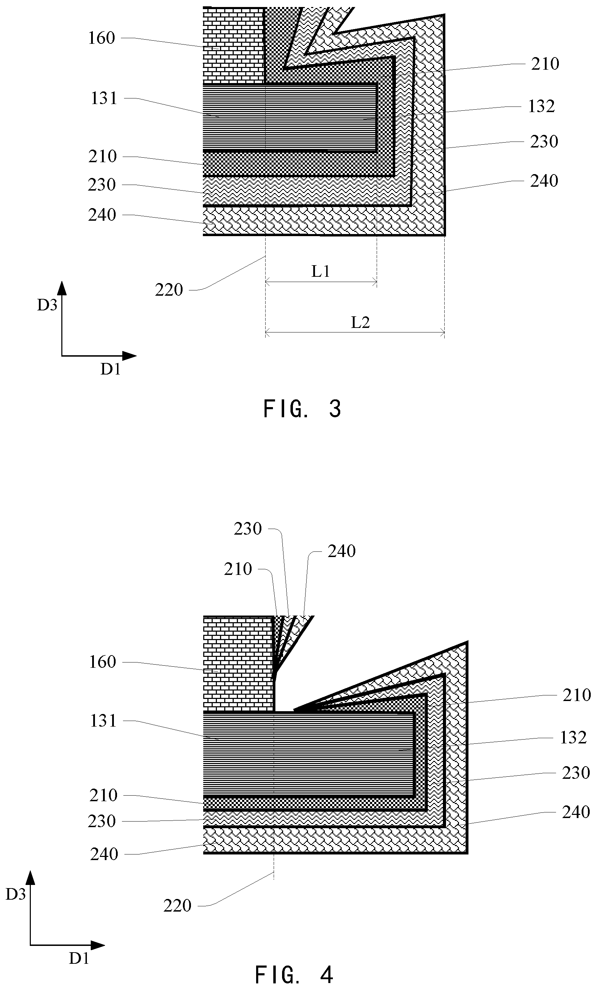

Referring to Fig. 2, the cantilever structure 130 includes a main portion 131 and an extension portion 132 that are in contact with each other in the first direction D1. The main portion 131 is in contact with a back side of the first electrode region, and the extension portion 132 protrudes from the first electrode region in the first direction D1. Fig. 3 is an enlarged schematic view of the dotted rectangular frame in Fig. 2. Referring to Fig. 2 and Fig. 3, the main portion 131 is located on the left side of the junction 220, and the extension portion 132 is located on the right side of the junction 220. The main portion 131 is directly formed on a surface of the first doped layer 160 away from the substrate 110, the left end of the extension portion 132 is in contact with the right end of the main portion 131 at junction 220, the right end of the extension portion 132 extends rightward along the first direction D1 and protrudes from the first doped layer 160, the size of the extension portion 132 in the first direction D1 is L1, and the size of L1 can be set according to actual conditions. In the first direction D1, the extension portion 132 protrudes from the first doped layer 160, and in the third direction D3, a space S is formed between the extension portion 132 and the first electrode region. In this way, the extension portion 132 is suspended.

The cantilever structure 130 may include one or more of silicon oxide, silicon nitride (SiN), and silicon oxynitride. Preferably, the material of the cantilever structure 130 is an insulating material. The cantilever structure 130 may contain the same doping elements as the doping elements in the first doped layer 160. The doping elements in the cantilever structure 130 may be intentionally added through a specific process, or may be diffused into the cantilever structure 130 from the doping elements in the first doped layer 160.

As shown in Fig. 2 and Fig. 3, the first passivation layer 210 and the second doped layer 230 extend continuously to the back side of the body portion 131. The thickness of the portion of the first passivation layer 210 located on the side of the second diffusion layer 150, the side of the tunneling layer 170, and the side of the first doped layer 160 gradually decreases in the direction close to the extension portion 132, and the thickness of the portion of the first passivation layer 210 located above the extension portion 132 gradually increases in the direction away from the body portion 131 (i.e., the first direction D1). Similarly, the thickness of the portion of the second doped layer 230 located on the side of the second diffusion layer 150, the side of the tunneling layer 170, and the side of the first doped layer 160 gradually decreases in the direction close to the extension portion 132, and the thickness of the portion of the second doped layer 230 located above the extension portion 132 gradually increases in the direction away from the body portion 131 (i.e., the first direction D1). The thickness of the first passivation layer 210 and the second doped layer 230 in contact with the side of the second diffusion layer 150, the tunneling layer 170 and the first doped layer 160 gradually decreases, which makes the conductivity of the portion of the first passivation layer 210 in contact with the first electrode region and the portion of the second doped layer 230 in contact with the first electrode region poor, thereby significantly reducing the short-circuit effect between the first passivation layer 210 and the first electrode region, and the short-circuit effect between the second doped layer 230 and the first electrode region. The reasons for the change in thickness of the first passivation layer 210 and the second doped layer 230 are as follows. In the process of forming the first passivation layer 210 and the second doped layer 230, the extension portion 132 has a shielding effect, so that the thickness of the first passivation layer 210 and the second doped layer 230 located in the shielded area changes.

The thickness of the first passivation layer 210 and the second doped layer 230 located on the side of the second diffusion layer 150, the side of the tunneling layer 170 and the side of the first doped layer 160 and the thickness of the first passivation layer 210 and the second doped layer 230 located above the extension portion 132 can be reduced by increasing L1.

In one embodiment, the first passivation layer 210 may be intrinsic amorphous silicon, and the intrinsic amorphous silicon may contain one or more of oxygen, carbon, and nitrogen, which are beneficial to improving the passivation effect of the first passivation layer 210 and reducing optical absorption loss. The thickness of the first passivation layer 210 may be any thickness in the range of 3 nm to 15 nm, for example, 5nm, 7nm, 9nm, 11nm, or 13nm.

The second doped layer 230 may be doped amorphous silicon and/or microcrystalline silicon, and the doped amorphous silicon and microcrystalline silicon may contain one or more of oxygen, carbon, and nitrogen. The thickness of the second doped layer 230 may be any value in the range of 3nm to 60nm, for example, 10nm, 20nm, 30nm, 40nm, or 50nm. The doping type of the second doped layer 230 is opposite to the doping type of the first doped layer 160.

In one embodiment, the solar cell further includes a transparent conductive layer 240. The transparent conductive layer 240 is located on the back side of the second doped layer 230. The thickness of the transparent conductive layer 240 located on the side of the second diffusion layer 150, the side of the tunneling layer 170, and the side of the first doped layer 160 gradually decreases in the direction close to the extension portion 132, and the thickness of the transparent conductive layer 240 located above the extension portion 132 gradually increases in the direction away from the body portion 131 (i.e., the first direction D1). The conductivity of the part of the transparent conductive layer 240 contacting the first electrode region is poor as the thickness of the transparent conductive layer 240 contacting the side of the second diffusion layer 150, the side of the tunneling layer 170, and the side of the first doped layer 160 gradually decreases, thereby significantly reducing the short circuit effect between the transparent conductive layer 240 and the first electrode region. The reason for the change in thickness of the transparent conductive layer 240 is as follows. In the process of forming the transparent conductive layer 240, the extension portion 132 has a shielding effect, so that the thickness of the transparent conductive layer 240 located in the shielded area changes.

The thickness of the transparent conductive layer 240 located on the side of the second diffusion layer 150, the side of the tunneling layer 170, and the side of the first doped layer 160 and the thickness of the transparent conductive layer 240 located above the extension portion 132 can be reduced by increasing L1.

The transparent conductive layer 240 may be selected from one or more of zinc oxide (ZnO), indium oxide (InO) and tin oxide (SnO), and the transparent conductive layer 240 may contain one or more of gallium (Ga), tin (Sn), molybdenum (Mo), cerium (Ce), fluorine (F), tungsten (W) and aluminum (Al).

Fig. 4 is an enlarged schematic view of the dotted rectangular frame in Fig. 2 in another embodiment. Referring to Figs. 2 to 4, similar to the first passivation layer 210 and the second doped layer 230 in Fig. 3, in Fig. 4, the thickness of the first passivation layer 210 located on the side of the second diffusion layer 150, the side of the tunneling layer 170 and the side of the first doped layer 160 gradually decreases in the direction close to the extension portion 132, and the thickness of the first passivation layer 210 located above the extension portion 132 gradually increases in the direction away from the body portion 131 (i.e., the first direction D1). Similarly, the thickness of the second doped layer 230 located on the side of the second diffusion layer 150, the side of the tunneling layer 170, and the side of the first doped layer 160 gradually decreases in the direction close to the extension portion 132, and the thickness of the second doped layer 230 located above the extension portion 132 gradually increases in the direction away from the body portion 131 (i.e., the first direction D1).

The differences between Fig. 4 and Fig. 3 include, that in Fig. 4 the first passivation layer 210 and the second doped layer 230 extend discontinuously to the back of the cantilever structure 130, the first passivation layer 210 is disconnected at the junction 220 between the main portion 131 and the extension portion 132, and the second doped layer 230 is also disconnected at the junction 220 between the main portion 131 and the extension portion 132. The discontinuous first passivation layer 210 can eliminate the short circuit effect between the first passivation layer 210 and the first electrode region, and the discontinuous second doped layer 230 can eliminate the short circuit effect between the second doped layer 230 and the first electrode region.

The embodiment of Fig. 4 may include a transparent conductive layer 240. The transparent conductive layer 240 is located on the back side of the second doped layer 230. The thickness of the transparent conductive layer 240 located on the side of the second diffusion layer 150, the tunneling layer 170 and the first doped layer 160 gradually decreases in the direction close to the extension portion 132, and the thickness of the transparent conductive layer 240 located above the extension portion 132 gradually increases in the direction away from the main portion 131 (i.e., the first direction D1). The transparent conductive layer 240 is disconnected at junction 220 between the main portion 131 and the extension portion 132. The discontinuous transparent conductive layer 240 can eliminate the short circuit effect between the transparent conductive layer 240 and the first electrode region.

Referring to Fig. 3, in one embodiment, a distance L2 between the left end of the extension portion 132 and the transparent conductive layer 240 located at the right end of the extension portion 132 is equal to or greater than 200 nm, for example, 400 nm, 600 nm, 800 nm, 1000 nm or 1200 nm.

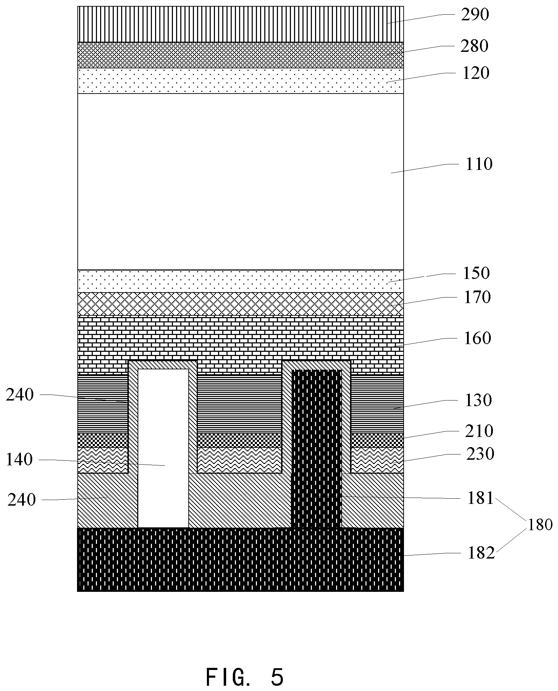

Fig. 5 is a schematic cross-sectional view of the solar cell along line B-B in Fig. 1. Referring to Fig. 1, Fig. 2, and Fig. 5, in one embodiment, the solar cell has a first grid 180 and a second grid 190. The first grid 180 is electrically connected to the first electrode region, and the second grid 190 is electrically connected to the second electrode region. Specifically, a plurality of contact holes 140 arranged at intervals on the second square D2 penetrate the transparent conductive layer 240, the second doped layer 230, the first passivation layer 210, and the cantilever structure 130, and the contact holes 140 expose the first doped layer 160, and at least a portion of the first grid 180 is in the contact holes 140. It can be understood that the contact holes 140 cannot be observed in Fig. 1, and the contact holes 140 in Fig. 1 are used to illustrate the positions of the contact holes 140.

The contact hole 140 may not penetrate the interior of the first doped layer 160, that is, the contact hole 140 exposes the surface of the first doped layer 160 away from the substrate 110. The contact hole 140 may also go deep into the interior of the first doped layer 160, that is, the contact hole 140 exposes the interior of the first doped layer 160. The contact hole 140 goes deep into the interior of the first doped layer 160 to increase the process window for forming the contact hole 140.

Referring to Fig. 2 and Fig. 5, in one embodiment, the first grid 180 includes a second contact portion 182 and a plurality of first contact portions 181. The first contact portion 181 is in the corresponding contact hole 140, and the second contact portion 182 is located outside the contact hole 140. One end of each first contact portion 181 contacts the first doped layer 160, and another end contacts the second contact portion 182. The width of the first contact portion 181 (the size of the first contact portion 181 in the first direction D1 in Fig. 2) is smaller than the width of the second contact portion 182 (the size of the second contact portion 182 in the first direction D1 in Fig. 2). For ease of understanding, Fig. 5 does not show the first grid 180 in the left contact hole 140.

The contact between the first grid 180 and the first doped layer 160 introduces metal-semiconductor recombination losses (J₀, metal), which reduces the efficiency of the solar cell. The contact area between the first grid 180 and the first doped layer 160 is reduced as the first grid 180 contacts the first doped layer 160 through the contact hole 140, thereby reducing the metal-semiconductor recombination losses and improving the efficiency of the solar cell.

Referring to Fig. 2 and 5, in one embodiment, the transparent conductive layer 240 is further formed on the sidewall and bottom surface of the contact hole 140, and the first grid 180 in the contact hole 140 is electrically connected to the first doped layer 160 through the transparent conductive layer 240 in the contact hole 140. In other embodiments, there is no transparent conductive layer 240 on the sidewall and bottom surface of the contact hole 140, and the first grid 180 in the contact hole 140 directly contacts the sidewall and bottom surface of the contact hole 140.

Referring to Fig. 1 and Fig. 2, in one embodiment, the solar cell further includes a first isolation groove 250 and a second isolation groove 260. The first isolation groove 250 and the second isolation groove 260 are arranged on both sides of the first grid 180 along the first direction D1, and the first isolation groove 250 and the second isolation groove 260 both penetrate the transparent conductive layer 240, the second doped layer 230 and the first passivation layer 210 located below the first region 112a. The first isolation groove 250 and the second isolation groove 260 can isolate the transparent conductive layer 240, the second doped layer 230, and the first passivation layer 210, thereby realizing electrical isolation between the first grid 180 and the adjacent second grid 190, and preventing the short circuit between the adjacent electrodes of the solar cell caused by the transparent conductive layer 240, the second doped layer 230 and the first passivation layer 210 connecting the first grid 180 and the second grid 190. In some other embodiments, the first isolation groove 250 and the second isolation groove 260 may go deep into the first doped layer 160 along the third direction D3 and do not penetrate the first doped layer 160. The first isolation groove 250 and the second isolation groove 260 may also penetrate only the transparent conductive layer 240.

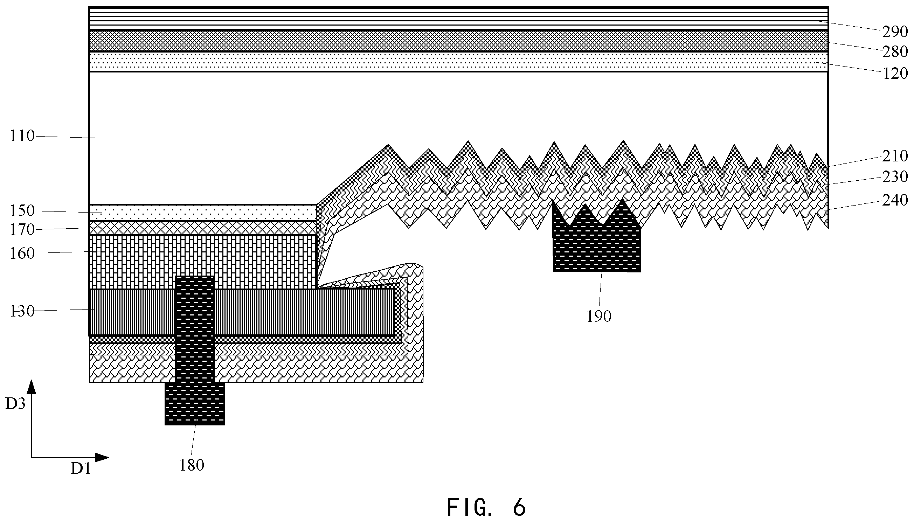

As described above, the thickness of the first passivation layer 210 and the second doped layer 230 that are in contact with the side of the second diffusion layer 150, the side of the tunneling layer 170 and the side of the first doped layer 160 gradually reduces, which can significantly reduce the short circuit effect. In this case, as shown in Figs. 6, 7 and 8, the short circuit between the adjacent two electrodes can be avoided without the first isolation groove 250 and the second isolation groove 260 in Fig. 2, thus saving the steps of forming the first isolation groove 250 and the second isolation groove 260.

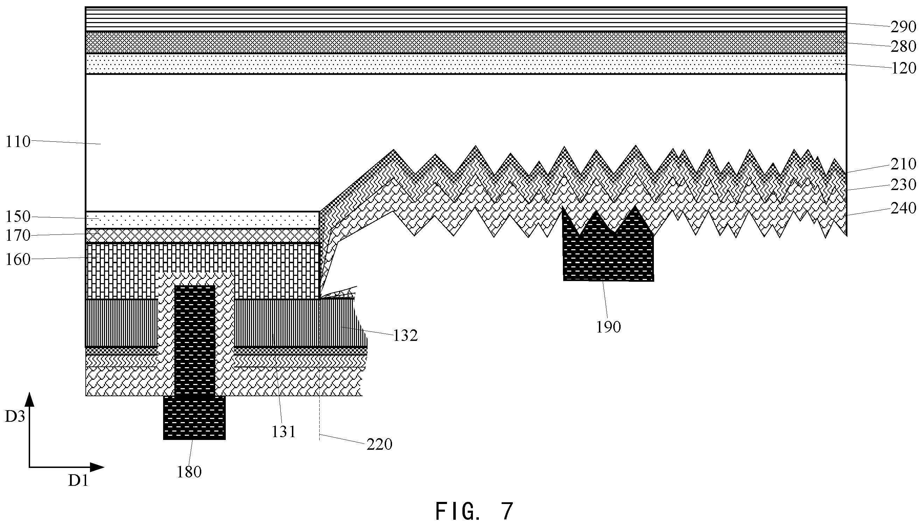

Referring to the cross-sectional schematic vies of a solar cell in another embodiment shown in Fig. 7. The cantilever structure in Fig. 7 is a broken cantilever structure. Specifically, a portion of the extension portion 132 away from the main portion 131 in the first direction D1 is broken, and the break is located on the right side of the junction 220. The broken cantilever structure physically disconnects the first passivation layer 210, the second doped layer 230 and the transparent conductive layer 240, thereby helping to prevent a short circuit between the adjacent electrodes. The number of cantilever structures in the solar cell is greater than one, and it may be that a portion of the cantilever structures are broken.

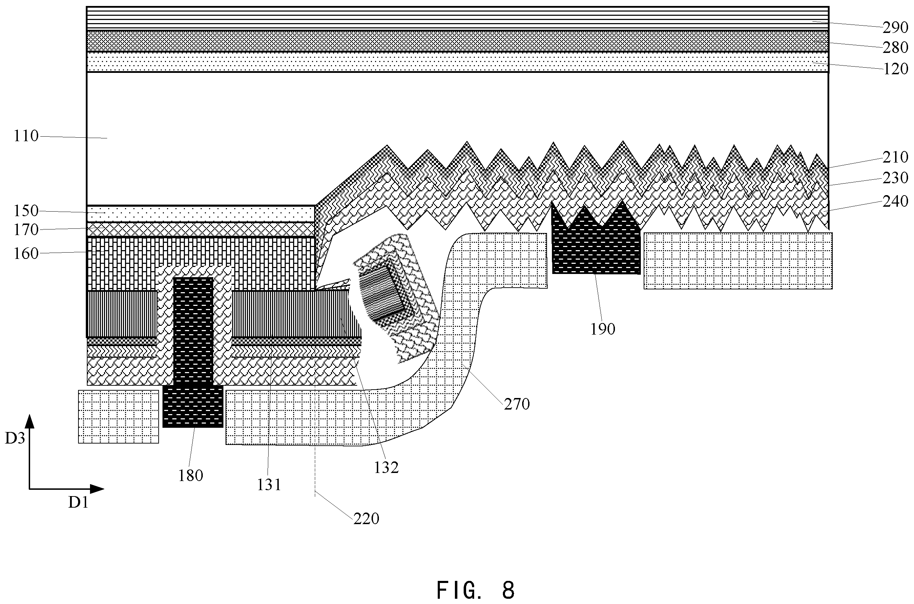

Referring to FIG. 8, a method for breaking the extension portion 132 is provided. In the process of printing the first grid 180 and the second grid 190, when the scraper scrapes over the extension portion 132, the mesh 270 presses and breaks the extension portion 132.

As shown in Fig. 2, in one embodiment, the solar cell further includes a first diffusion layer 120. The first diffusion layer 120 is located above the substrate 110. The first diffusion layer 120 may be crystalline silicon, and the doping type of the first diffusion layer 120 may be the same as that of the substrate 110, or may be opposite to that of the substrate 110. The doping concentration of the first diffusion layer 120 is equal to or greater than the doping concentration of the substrate 110. The thickness of the first diffusion layer 120 may be any value within the range of 10 nm to 1500 nm.

In one embodiment, the solar cell further includes a second passivation layer 280 and an anti-reflection layer 290. The second passivation layer 280 and the anti-reflection layer 290 are sequentially arranged on the surface of the first diffusion layer 120 away from the substrate 110 along the third direction D3. The second passivation layer 280 can be selected from intrinsic amorphous silicon, amorphous silicon containing one or more elements of oxygen, carbon and nitrogen, silicon oxide, silicon oxynitride or aluminum oxide. The second passivation layer 280 has a passivation effect and can improve the efficiency of the solar cell. In one embodiment, the thickness of the second passivation layer 280 is equal to or greater than 1.5nm. The anti-reflection layer 290 can select dielectric materials such as silicon oxide and silicon oxynitride. The thickness of the anti-reflection layer 290 is equal to or greater than 40nm. The anti-reflection layer 290 can increase the absorption of incident light by the solar cell, thereby improving the utilization rate of the incident light by the solar cell.

In some embodiments, the solar cell 100 may not have the first diffusion layer 120, and the second passivation layer 280 is directly formed on the front surface of the substrate 110.

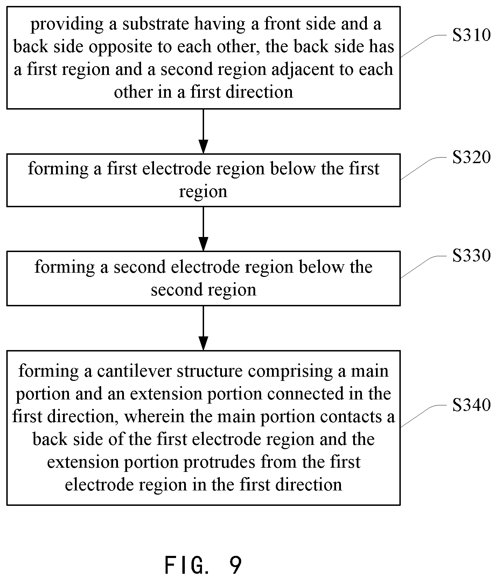

The present application also provides a method for manufacturing a solar cell. Referring to Fig. 9, which is a schematic flow chart of a method for manufacturing a solar cell according to an embodiment, the embodiment includes the following steps:
Step S310: providing a substrate having a front side and a back side opposite to each other, and the back side has a first region and a second region adjacent to each other in a first direction;
Step S320: forming a first electrode region below the first region;
Step S330: forming a second electrode region below the second region;
Step S340: forming a cantilever structure comprising a main portion and an extension portion connected in the first direction, wherein the main portion contacts a back side of the first electrode region, and the extension portion protrudes from the first electrode region in the first direction.

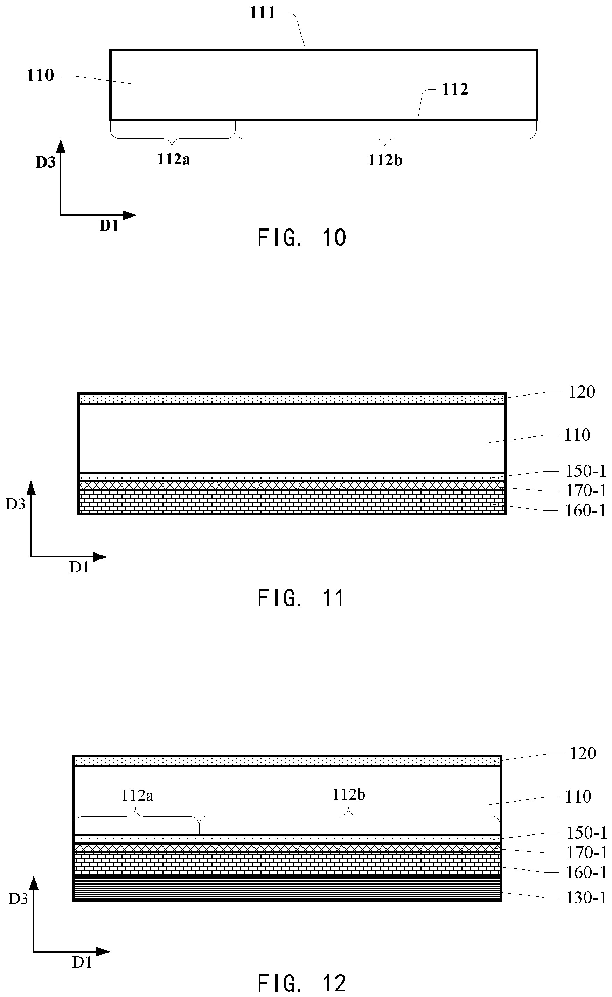

Figs. 10 to 17 are cross-sectional views of a solar cell in the process of manufacturing the solar cell. Steps S310 to step S340 are described in conjunction with Fig. 10 to Fig. 17.

Referring to Fig. 10, in step S310, a substrate 110 is provided. The substrate 110 has a front surface 111 and a back side 112 opposite to each other. The back side 112 has a first region 112a and a second region 112b adjacent to each other in a first direction D1.

Referring to Figs. 8 to 13, in step S320, a first electrode region is formed below the first region 112a. The first electrode region includes a tunneling layer 170 and a first doped layer 160. In some embodiments, the first electrode region further includes a second diffusion layer 150, the second diffusion layer 150 is directly formed in the first region 112 a, and the tunneling layer 170 and the first doped layer 160 are sequentially stacked on a surface of the second diffusion layer 150 away from the substrate 110.

Referring to Figs.10 to 12, a first diffusion layer 120 is formed on the front surface 111 of the substrate 110, and an initial second diffusion layer 150-1, an initial tunneling layer 170-1, an initial first doped layer 160-1 and an initial cantilever structure 130-1 are sequentially formed on the back side 112.

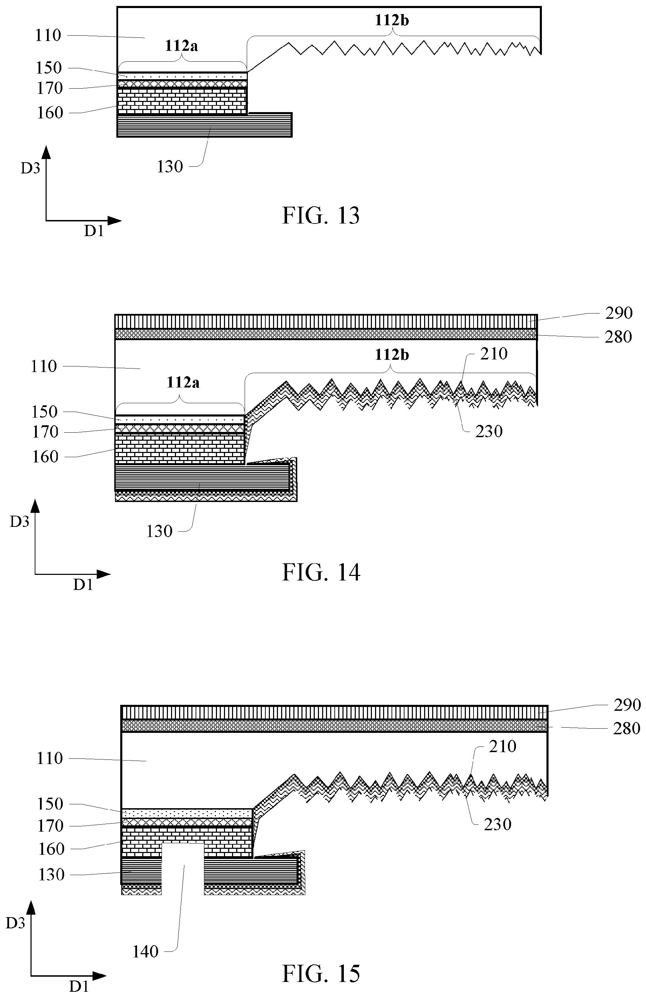

Referring to Fig. 12 and Fig. 13, in some embodiments, the first diffusion layer 120 may not be formed, or the first diffusion layer 120 may be removed after the first diffusion layer 120 is formed. In some embodiments, the initial second diffusion layer 150-1 may not be formed, in which case the tunneling layer 170 is directly formed in the first region 112a, and the first doped layer 160 is formed on the surface of the tunneling layer 170 away from the substrate 110.

Next, referring to Figs. 12 and 13, the initial second diffusion layer 150-1, the initial tunneling layer 170-1, the initial first doped layer 160-1, and the initial cantilever structure 130-1 at the second region 112b are removed, and the initial second diffusion layer 150-1, the initial tunneling layer 170-1, the initial first doped layer 160-1 and the initial cantilever structure 130-1 at the first region 112a are retained. The retained initial second diffusion layer 150-1, the initial tunneling layer 170-1, the initial first doped layer 160-1, and the initial cantilever structure 130-1 become the second diffusion layer 150, the tunneling layer 170, the first doped layer 160 and the cantilever structure 130, respectively.

Referring to Fig. 13 and Fig. 14, in step S330, a second electrode region is formed below the second region 112b. Specifically, a first passivation layer 210 and a second doped layer 230 are sequentially formed below the second region 112b, and the first passivation layer 210 and the second doped layer 230 extend to the back of the cantilever structure 130, wherein the first passivation layer 210 located below the second region 112b is directly formed on the second region 112b, and the second doped layer 230 located below the second region 112b is directly formed on the surface of the first passivation layer 210 away from the substrate 110. The second electrode region includes the first passivation layer 210 and the second doped layer 230 formed on the second region 112b. In some other embodiments, the solar cell may not have the first passivation layer 210, and the second doped layer 230 is directly formed in the second region 112b and extends to the back of the cantilever structure 130.

Referring to Figs. 2 and 3, in one embodiment, the first passivation layer 210 and the second doped layer 230 continuously extend to the back side of the cantilever structure 130. The thickness of the portion of the first passivation layer 210 located on the side of the first electrode region gradually decreases in the direction close to the extension portion 132, and the thickness of the portion of the first passivation layer 210 located above the extension portion 132 gradually increases in the direction away from the body portion 131. The thickness of the portion of the second doped layer 230 located on the side of the first electrode region gradually decreases in the direction close to the extension portion 132, and the thickness of the portion of the second doped layer 230 located above the extension portion gradually increases in the direction away from the body portion 131.

As shown in Fig. 2 and Fig. 4, in another embodiment, the first passivation layer 210 and the second doped layer 230 extend discontinuously to the back of the cantilever structure 130, and the first passivation layer 210 and the second doped layer 230 are disconnected at the junction 220 between the main portion 131 and the extension portion 132. The thickness of the portion of the first passivation layer 210 located on the side of the first electrode region gradually decreases in the direction close to the extension portion 132, and the thickness of the portion of the first passivation layer 210 located above the extension portion 132 gradually increases in the direction away from the main portion 131. The thickness of the portion of the second doped layer 230 located on the side of the first electrode region gradually decreases in the direction close to the extension portion 132, and the thickness of the portion of the second doped layer 230 located above the extension portion 132 gradually increases in the direction away from the main portion 131. For other descriptions of the thickness changes of the first passivation layer 210 and the second doped layer 230, please refer to the relevant descriptions above, which will not be expanded here.

Referring to Figs. 2, 12 and 13, in step S340, a cantilever structure 130 is formed below the first region 112a. The cantilever structure 130 includes a main portion 131 and an extension portion 132 connected in a first direction D1, the main portion 131 contacts the back side of the first electrode region, and the extension portion 132 protrudes from the first electrode region in the first direction D1.

The method of forming the cantilever structure 130 includes: in the process of forming the pyramid texture in the second region 112b, the chemical reagent has different etching rates for different materials, so that the etching amount of the chemical reagent on the initial second diffusion layer 150-1, the initial tunneling layer 170-1 and the initial first doped layer 160-1 is greater than the etching amount on the initial cantilever structure 130-1, thereby forming an extension portion 132 protruding from the second diffusion layer 150, the tunneling layer 170 and the first doped layer 160 in the first direction D1 . For other descriptions of the cantilever structure, please refer to the previous part, which will not be expanded here.

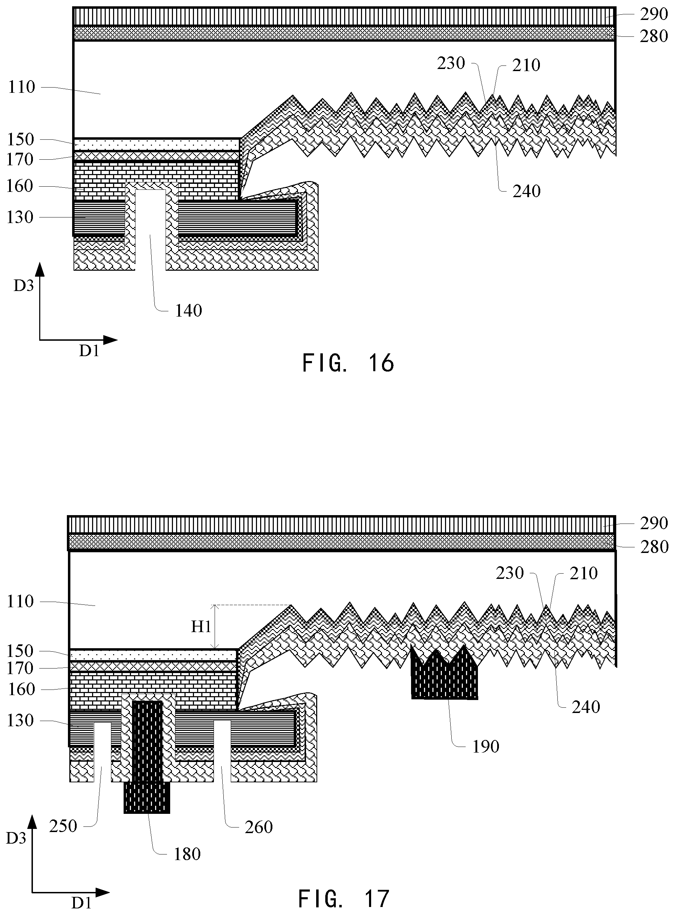

Referring to Figs. 15 to 17, a first grid 180 and a second grid 190 are formed. Specifically, referring to Fig. 15, a contact hole 140 is formed that penetrates the first passivation layer 210, the second doped layer 230, and the cantilever structure 130, and the contact hole 140 exposes the first doped layer 160. Referring to Figs. 15 and 16, a transparent conductive layer 240 is formed on the surface of the second doped layer 230 away from the substrate 110, and the transparent conductive layer 240 covers the sidewall and bottom surface of the contact hole 140. Referring to Figs. 16 and 17, a first grid 180 is formed in the contact hole 140, and a transparent conductive layer 240 is formed between the first grid 180 and the bottom surface of the contact hole 140, and between the first grid 180 and the sidewall of the contact hole 140. In some other embodiments, the contact hole 140 is formed after the first grid 180 is formed, and the first grid 180 is formed in the contact hole 140. In this case, the sidewall and bottom surface of the contact hole 140 are not covered with the transparent conductive layer 240, and the first grid 180 directly contacts the sidewall and bottom surface of the contact hole 140.

Referring to Figs. 2 and 5, the first grid 180 includes a second contact portion 182 and a plurality of first contact portions 181, each of the first contact portions 181 is located in the corresponding contact hole 140, one end of each first contact portion 181 is in electrical contact with the first doped layer 160, and another end is in electrical contact with the second contact portion 182. In one embodiment, the width of each first contact portion 181 (the size of the first contact portion 181 in the first direction D1 in Fig. 2) is smaller than the width of the second contact portion 182 (the size of the second contact portion 182 in the first direction D1 in Fig. 2).

As shown in Fig. 3, the thickness of the portion of the transparent conductive layer 240 located on the side of the first electrode region gradually decreases in the direction close to the extension portion 132, and the thickness of the portion of the transparent conductive layer 240 located above the extension portion 132 gradually increases in the direction away from the main portion 131. As shown in Fig. 3, the transparent conductive layer 240 can extend continuously from the second region 112b to the first region 112a. As shown in Fig. 4, the transparent conductive layer 240 can also extend discontinuously from the second region 112b to the first region 112a, that is, the transparent conductive layer 240 is disconnected at the junction 220.

As shown in Fig. 3, the distance L2 between the left end of the extension portion 132 and the transparent conductive layer 240 located at the right end of the extension portion 132 is equal to or greater than 200 nm, for example, 400 nm, 600 nm, 800 nm, 1000 nm or 1200 nm. Referring to Fig. 17, in one embodiment, the maximum distance between the pyramid texture at the second region and the second diffusion layer 150 in the third direction D3 is H1, and H1 is equal to or greater than 0.2 µm, for example, 0.5 µm, 1 µm or 1.5 µm. In combination with Fig. 2, in some other embodiments, H1 is equal to or greater than the sum of the thicknesses of the second diffusion layer 150, the tunneling layer 170, and the first doped layer 160. In combination with Fig. 3 and Fig. 17, L1 can be increased by increasing H1.

In one embodiment, as shown in Fig. 17, a first isolation groove 250 and a second isolation groove 260 are formed. The first isolation groove 250 and the second isolation groove 260 are located on both sides of the first grid 180 and both penetrate the transparent conductive layer 240, the second doped layer 230, and the first passivation layer 210.

In one embodiment, a second passivation layer 280 and an anti-reflection layer 290 are sequentially formed on the substrate 110.

For other details about the manufacturing method of the present application, please refer to the above description of the solar cell, which will not be elaborated on here.

The basic concepts have been described above. Obviously, for those skilled in the art, the above disclosure is only an example and does not constitute a limitation to the present application. Although not expressly stated here, various modifications, improvements and amendments to this application may be made by those skilled in the art. Such modifications, improvements, and amendments are suggested in this application, so such modifications, improvements, and amendments still belong to the spirit and scope of the exemplary embodiments of this application.

And, the present application uses specific words to describe the embodiments of the present application. For example, "one embodiment", "an embodiment", and/or "some embodiments" refer to a certain feature, structure or characteristic related to at least one embodiment of the present application. Therefore, it should be emphasized and noted that two or more references to "an embodiment" or "an embodiment" or "an alternative embodiment" in different places in this specification do not necessarily refer to the same embodiment. In addition, certain features, structures, or characteristics of one or more embodiments of the present application may be properly combined.

In some embodiments, numbers describing the quantity of components and attributes are used. It should be understood that such numbers used in the description of the embodiments use the modifiers "about", "approximately" or "substantially" in some examples for grooming. Unless otherwise stated, "about", "approximately" or "substantially" indicates that the stated figure allows for a variation of ± 20%. Accordingly, in some embodiments, the numerical parameters used in the specification and claims are approximations that can vary depending upon the desired characteristics of individual embodiments. In some embodiments, numerical parameters should take into account the specified significant digits and adopt the general digit reservation method. Although the numerical ranges and parameters used in some embodiments of the present application to confirm the breadth of the scope are approximate values, in specific embodiments, such numerical values are set as precisely as practicable.

## Claims

1. A solar cell, **characterized by** comprising:
a substrate having a front side and a back side opposite to each other, and the back side has a first region and a second region adjacent to each other in a first direction;
a first electrode region disposed below the first region;
a second electrode region disposed below the second region;
a cantilever structure comprising a main portion and an extension portion connected in the first direction, wherein the main portion contacts a back side of the first electrode region, the extension portion protrudes from the first electrode region in the first direction; and
a first passivation layer and a second doped layer located below the first region and the second region, wherein the first passivation layer and the second doped layer extend from the second region to a back side of the cantilever structure, the second electrode region includes a first passivation layer and a second doped layer formed on the second region, a thickness of a portion of the first passivation layer located on a side of the first electrode region gradually decreases in a direction approaching the extension portion, and a thickness of a portion of the second doped layer located on a side of the first electrode region gradually decreases in a direction approaching the extension portion.

2. The solar cell according to claim 1, **characterized in that** the first electrode region comprises a tunneling layer and a first doped layer, and the tunneling layer and the first doped layer are sequentially arranged below the first region.

3. The solar cell according to claim 1, **characterized in that** the first passivation layer and the second doped layer continuously extend to the back side of the cantilever structure.

4. The solar cell according to claim 3, **characterized in that** a thickness of a portion of the first passivation layer located above the extension portion gradually increases in a direction away from the main portion, and a thickness of a portion of the second doped layer located above the extension portion gradually increases in a direction away from the main portion.

5. The solar cell according to claim 1, **characterized in that** the first passivation layer and the second doped layer extend discontinuously to the back side of the cantilever structure, wherein the first passivation layer and the second doped layer are disconnected at a junction of the main portion and the extension portion.

6. The solar cell according to claim 5, **characterized in that** a thickness of a portion of the first passivation layer located above the extension portion gradually increases in a direction away from the main portion, and a thickness of a portion of the second doped layer located above the extension portion gradually increases in a direction away from the main portion.

7. The solar cell as according to claims 4 or 6, **characterized by** further comprising a transparent conductive layer located on a back side of the second doped layer, wherein a thickness of a portion of the transparent conductive layer located on a side of the first electrode region gradually decreases in a direction approaching the extension portion, and a thickness of a portion of the transparent conductive layer located above the extension portion gradually increases in a direction away from the main portion.

8. The solar cell according to claim 7, **characterized in that** a distance between a left end of the extending portion and the transparent conductive layer located at a right end of the extending portion is equal to or greater than 200 nm.

9. The solar cell according to claim 1, **characterized by** further comprising a first grid and a second grid, wherein the first grid is in electrical contact with the first electrode region through a contact hole.

10. The solar cell according to claim 9, **characterized in that** the first grid includes a second contact portion and a plurality of first contact portions, each of the first contact portions is in a corresponding contact hole, one end of each of the first contact portions contacts the first electrode region, and another end contacts the second contact portion.

11. The solar cell according to claim 10, **characterized in that** a width of each of the first contact portions is smaller than a width of the second contact portion.

12. A method for manufacturing a solar cell, **characterized by** comprising:
providing a substrate having a front side and a back side opposite to each other, and the back side has a first region and a second region adjacent to each other in a first direction;
forming a first electrode region below the first region;
forming a second electrode region below the second region;
forming a cantilever structure comprising a main portion and an extension portion connected in the first direction, wherein the main portion contacts a back side of the first electrode region, the extension portion protrudes from the first electrode region in the first direction; and
forming a first passivation layer and a second doped layer, the first passivation layer and the second doped layer extending from the second region to a back side of the cantilever structure, wherein the second electrode region includes a first passivation layer and a second doped layer formed on the second region, and a thickness of a portion of the first passivation layer located on a side of the first electrode region gradually decreases in a direction approaching the extension portion, a thickness of a portion of the second doped layer located on the side of the first electrode region gradually decreases in a direction approaching the extension portion.

13. The method according to claim 12, **characterized in that** the first electrode region comprises a tunneling layer and a first doped layer, and the tunneling layer and the first doped layer are sequentially arranged below the first region.

14. The method according to claim 12, wherein the first passivation layer and the second doped layer extend continuously to the back side of the cantilever structure.

15. The method according to claim 14, **characterized in that** a thickness of a portion of the first passivation layer located above the extension portion gradually increases in a direction away from the main portion, and a thickness of a portion of the second doped layer located above the extension portion gradually increases in a direction away from the main portion.

16. The method according to claim 12, **characterized in that** the first passivation layer and the second doped layer extend discontinuously to the back side of the cantilever structure, wherein the first passivation layer and the second doped layer are disconnected at a junction of the main portion and the extension portion.

17. The method according to claim 16, **characterized in that** a thickness of a portion of the first passivation layer located above the extension portion gradually increases in a direction away from the main portion, and a thickness of a portion of the second doped layer located above the extension portion gradually increases in a direction away from the main portion.

18. The method according to claims 15 or 17, **characterized by** further comprising forming a transparent conductive layer located on a back side of the second doped layer, wherein a thickness of a portion of the transparent conductive layer located on a side of the first electrode region gradually decreases in a direction approaching the extension portion, and a thickness of a portion of the transparent conductive layer located above the extension portion gradually increases in a direction away from the main portion.

19. The method according to claim 18, **characterized in that** a distance between a left end of the extension portion and the transparent conductive layer located at a right end of the extension portion is equal to or greater than 200 nm.

20. The method according to claim 12, **characterized by** further comprising forming a first grid and a second grid, wherein the first grid is electrically in contact with the first electrode region through a contact hole.

21. The method according to claim 20, **characterized in that** the first grid is formed after forming the transparent conductive layer, or the first grid is formed before forming the transparent conductive layer.

22. The method according to claim 20, **characterized in that** the first grid includes a second contact portion and a plurality of first contact portions, each of the first contact portions is in a corresponding contact hole, one end of each of the first contact portions contacts the first electrode region, and another end contacts the second contact portion.

23. The method according to claim 22, **characterized in that** a width of each of the first contact portions is smaller than a width of the second contact portion.
